**Europäisches Patentamt**

**European Patent Office**

**Office européen des brevets**

(19)

(11) Veröffentlichungsnummer: **0 322 641 B1**

## (12) EUROPÄISCHE PATENTSCHRIFT

(45) Veröffentlichungstag der Patentschrift: **20.05.92**

(51) Int. Cl.⁵: **C23C 18/30**

(21) Anmeldenummer: **88120876.3**

(22) Anmeldetag: **14.12.88**

(54) **Verfahren zur Verbesserung der Haftfestigkeit von stromlos abgeschiedenen Metallschichten auf Polymidoberflächen.**

(30) Priorität: **23.12.87 DE 3743780**

(43) Veröffentlichungstag der Anmeldung:
**05.07.89 Patentblatt 89/27**

(45) Bekanntmachung des Hinweises auf die
Patenterteilung:
**20.05.92 Patentblatt 92/21**

(84) Benannte Vertragsstaaten:
**AT BE CH DE FR GB IT LI NL**

(56) Entgegenhaltungen:
**EP-A- 0 125 617**
**EP-A- 0 156 987**
**US-A- 3 523 824**
**US-A- 3 881 049**
**US-A- 4 368 281**

(73) Patentinhaber: **BAYER AG**

**W-5090 Leverkusen 1 Bayerwerk(DE)**

(72) Erfinder: **Giesecke, Henning, Dr.**
**Düsseldorfer Strasse 49**
**W-5000 Köln 80(DE)**
Erfinder: **Wolf, Gerhard Dieter, Dr.**
**Wilhelm-Busch-Strasse 29**
**W-4047 Dormagen 5(DE)**
Erfinder: **Zecher, Wilfried, Dr.**
**Treptower Strasse 6**
**W-5090 Leverkusen 1(DE)**

**Beschreibung**

Es ist allgemein bekannt, daß man zum Zwecke der Erzielung haftfester Metallauflagen auf elektrisch nicht leitenden Trägerkörpern zunächst einen haftvermittelnden Lack auf der Basis von vorzugsweise ABS-Polymerisaten auf die Oberfläche aufträgt. Der Nachteil dieser Vorbehandlungsmethode besteht jedoch darin, daß der mit dieser Lackschicht überzogene Formkörper vor der eigentlichen Metallisierung zwecks Aufrauhung der Oberfläche mit einer Beize behandelt werden muß (vgl. z.B. DE-A-1 958 839).

Es ist deshalb bereits vorgeschlagen worden, nichtmetallische Substratoberflächen ohne vorheriges Beizen direkt mit Aktivatorlösungen für die stromlose Metallisierung zu behandeln, die als Haftvermittler komplizierte Gemische aus Acrylnitril/Butadien-Copolymerisaten und gegebenenfalls Phenolharzen enthalten (vgl. z.B. US-A-3 305 460 und 3 560 257).

Ein derartiges Verfahren konnte sich jedoch bisher in der Technik nicht durchsetzen, da die Haftfestigkeit der erzeugten Metallschichten nicht ausreichend ist und die haftvermittelnden Polymere die insbesondere in der Leiterplattentechnick geforderten hohen Anforderungen an die thermischen und elektrischen Eigenschaften nicht erfüllen.

Das Verfahren gemäß US-A-4 368 281 liefert demgegenüber zwar bessere Haftfestigkeiten, jedoch werden dafür verhältnismäßig große Aktivatormengen, nämlich 5 bis 16 Gew.-%, benötigt.

Es wurde nun gefunden, daß man ohne die genannten Nachteile gut haftende Metallschichten auf Polyimidoberflächen aufbringen kann, wenn man diese mit Druckpastenformulierungen behandelt, die als wesentliche Bestandteile

a) 0,03 - 4,00 Gew-% einer organo-metallischen Edelmetallverbindung als Aktivator,

b) 3 - 40 Gew.-% eines Polyimids,

c) 1 - 30 Gew.-% eines Füllstoffs und

d) 45 - 90 Gew.-% eines Lösungsmittels

enthalten.

Es ist überraschend, daß die erfindungsgemäßen Formulierungen auch in sehr dünnen Schichten (um 1 $\mu$m) eine haftfeste Metallisierung bewirken, ist doch aus der Leiterplattenindustrie bekannt, daß für eine haftfeste Verklebung von Polyimidfolien mit Kupfer Klebeschichten um 25 $\mu$m erforderlich sind.

Bevorzugte Druckpasten enthalten 0,05 bis 3 % an Komponente a), je 5 bis 25 % an Komponente b) und c) und 60 bis 80 % an Komponente d).

Unter "Polyimiden" werden im Rahmen dieser Erfindung verstanden: aliphatische, aliphatisch-aromatische und aromatische Polyimide und deren Varianten wie Polyamidimide, Polyetherimide und Polyesterimide sowie deren Cokondensate und Mischungen. Die Herstellung erfolgt beispielsweise durch Kondensation von cyclischen Polycarbonsäureanhydriden, Polycarbonsäurecarbonsäureanhydriden, Polycarbonsäuren oder deren Estern mit Polyaminen, Polyamiden, Polyisocyanaten oder Polycarbamidsäureestern. Die erfindungsgemäßen Bindemittel können als Polymere oder als oligomere Imide oder Polyamidsäuren, die nach der Applikation noch auskondensiert werden, eingesetzt werden (z.B. D.I. De Renzo, Wire Coatings, Noyes Dato Corporation 1971, S. 89 - 119, "Polyimides" - K.L. Mittal, Plenum Press 1984).

Bevorzugt eingesetzt werden aliphatisch-aromatische Polyamidimide, wie sie durch Kondensation von z.B. Trimellitsäureanhydrid mit Polyisocyanaten und Lactamen oder Polyamiden erhalten werden und in DE-A-1 770 202, 1 956 512 und 2 542 706 sowie US-A-4 549 006 und 4 628 079 beschrieben werden.

Als besonders geeignet haben sich Polyamidimide erwiesen, die aus Trimellitsäureanhydrid, Caprolactam und 4,4$'$-Diisocyanatodiphenylmethan oder aus Abmischungen von 4,4$'$-Diisocyanatodiphenylmethan und technischen Gemischen aus 2,4- und 2,6-Toluylendiisocyanat gemäß DE-A-1 770 202 und US-A-4 546 162 erhalten werden, Die Herstellung kann bevorzugt in phenolischen Lösungsmitteln, z.B. in technischen Kresol-Gemischen, erfolgen, aus denen das Polyamidimid dann z.B. mit Methanol ausgefällt wird. Eine weitere Ausführungsform besteht darin, daß die Lösung des Polyamidimids bis zu einem Festgehalt von ca. 75 Gew.-% aufkonzentriert wird. Man erhält eine Schmelze des Polyamidimids, die beim Erkalten zu einem spröden Harz erstarrt. Aus dem Harz können durch Extraktion mit z.B. Methanol die Lösungsmittel-Anteile entfernt werden und man erhält als Rückstand die erfindungsgemäßen Polyamidimide.

Als Aktivatoren kommen in den erfindungsgemäßen Formulierungen organometallische Verbindungen der 1. oder 8. Nebengruppen des Periodensystems (insbesondere Pd, Pt, Au und Ag) in Betracht, wie sie beispielsweise in den EP-A-34 485, 81 438, 131 195 beschrieben werden. Besonders geeignet sind organometallische Verbindungen des Palladiums mit Olefinen (Dienen), mit $\alpha$, $\beta$-ungesättigtenCarbonylverbindungen, mit Kronenethern und mit Nitrilen. Ganz besonders geeignet sind Butadienpalladiumdichlorid, Bisacetonitrilpalladiumdichlorid, 4-Cyclohexen-1,2-dicarbonsäureanhydridpalladiumdichlorid, Mesityloxidpalladiumchlorid, 3-Hepten-2-on-palladiumchlorid, 5-Methyl-3-hexen-2-on-palladiumchlorid.

Selbstverständlich können auch Gemische dieser Verbindungen eingesetzt werden. Sie können in den Formulierungen gelöst oder dispergiert vorliegen. Eine Lösung kann dabei auch durch Zusatz von Lösungsvermittlern hergestellt werden, z.B. von quaternären Ammoniumsalzen, wie Tetrabutylammoniumbromid. Bei einer Dispergierung der Aktivatoren ist dafür zu sorgen, daß Teilchengrößen unterhalb von 1 $\mu$m erreicht werden.

Besonders geeignet für das erfindungsgemäße Verfahren sind Formulierungen, die neben den Aktivatoren und den erfindungswesentlichen Bindemitteln Lösungsmittel. Füllstoffe sowie gegebenenfalls Tenside u.a. Hilfsmittel enthalten.

Als Lösungsmittel in den erfindungsgemäßen Formulierungen kommen in der Druck- bzw. Lackiertechnick bekannte Substanzen in Betracht wie aromatische und aliphatische Kohlenwasserstoffe, beispielsweise Toluol, Xylol, Benzin, Petrolether; Glyzerin; Ketone, beispielsweise Aceton, Methylethylketon, Cyclohexanon, Methylisobutylketon; Ester, beispielsweise Essigsäurebutylester, Phthalsäuredioctylester, Glykolsäurebutylester; Glykolether, beispielsweise Ethylenglykolmonomethylether, Diglyme, Propylenglykolmonomethylether; Ester von Glykolethern, beispielsweise Ethylglykolacetat, Propylenglykolmonomethyletheracetat; Diacetonalkohol. Selbstverständlich können auch Gemische dieser Lösungsmittel und ihre Verschnitte mit anderen Lösungsmitteln eingesetzt werden.

Besonders geeignet für das Verfahren sind aber Lösungsmittel, die Polyimide bzw. Polyamidimide oder ihre Vorstufen anlösen oder anquellen. Als Beispiele seien genannt: Dimethylformamid, N-Methylpyrrolidon, Butyrolacton, N-Methylcaprolactam, Dimethylacetamid und Hexamethylphosphorsäuretriamid.

Die erfindungsgemäß neuen Formulierungen können mit dieser Lösungsmittel angesetzt werden bzw. diese Lösungsmittel gemischt mit Verschnittmitteln enthalten.

Als Füllstoffe kommen aus der Druck- bzw. Lackierungstechnik bekannte Hilfsstoffe wie Pigmente, disperse Kieselsäuren, Tonmineralien, Ruße und rheologische Additive in Betracht.

Als Beispiele seien genannt:

Aerosile, $TiO_2$, Talkum, Eisenoxide, Kieselgur, Schwerspate, Kaoline, Quarzmehl, Smectite, Farbruße, Graphite, Zinksulfide, Chromgelb, Bronzen, organische Pigmente und Kreide. Bevorzugt sind Aerosile, Schwerspate und $TiO_2$.' Selbstverständlich sind auch Mischungen der Füllstoffe vorteilhaft einsetzbar.

Neben den Aktivatoren, Füllstoffen, Bindemitteln und Lösemitteln enthalten die Formulierungen gegebenenfalls Tenside, Verlaufsmittel und/oder Farbstoffe.

Die Herstellung der erfindungsgemäßen Formulierungen geschieht im allgemeinen durch Vermischen der Bestandteile. Dazu sind neben den eingachen Rührern besonders die in der Lack- und Drucktechnik üblichen Naßverkleinerungsaggregate wie Kneter, Attritore, Walzenstühle, Dissolver, Rotor-Stator-Mühlen, Kugelmühlen sowie Rührwerkmühlen besonders geeignet. Selbstverständlich kann das Einarbeiten der Formulierungsbestandteile auch in getrennten Schritten durchgeführt werden. Beispielsweise kann man den Aktivator zuerst in den Bindern und Lö sungsmitteln lösen bzw. dispergieren und dann erst die Füllstoffe einarbeiten. Auch ein vorheriges Anteigen der Füllstoffe in den Lösungsmitteln unter hohen Scherkräften ist eine mögliche Verfahrensvariante.

Durch Aufbringen der erfindungsgemäßen Formulierungen können Oberflächen zum Zweck einer haftfesten chemogalvanischen Metallisierung aktiviert werden. Das Aufbringen erfolgt im allgemeinen durch aus der Lack- bzw. Drucktechnik bekannte Verfahren.

Als Beispiels seien genannt:

Aufsprühen, Aufpinseln, Aufrollen, Offsetdruck, Siebdruck, Tampondruck, Tiefdruck, Tauchen.

Als Substrate für das erfindungsgemäße Verfahren kommen Polyimid- oder polyimidähnliche Oberflächen in Betracht. Polyimide werden beispielsweise in K.L. Mittal: "Polyimides" Plenum Press 1984 oder D.J. De Renzo: "Wire Coatings" Noyes Data Corporation 1971, S. 89 - 119 beschrieben. Unter polyimidähnlichen Oberflächen werden Substrate verstanden, die neben Polyimidgruppen noch andere funktionelle Gruppen wie beispielsweise Amidgruppen, Estergruppen, Ethergruppen, Sulfongruppen oder Sulfatgruppen enthalten.

Nach dem Aufbringen der erfindungsgemäßen Formulierungen auf die Oberfläche werden die Lösungsmittel entfernt. Im allgemeinen geschieht dies durch Trocken.

Das Trocknen kann bei unterschiedlichen Temperaturen, beispielsweise zwischen RT und 350°C und unter Normaldruck oder auch in Vakuum erfolgen. Die Trocknungszeit kann selbstverständlich stark variiert werden.

Die so bekeimten Oberflächen müssen anschließend durch Reduktion aktiviert werden. Dazu können bevorzugt die in der Galvanotechnik üblichen Reduktionsmittel, wie z.B. Formaldehyd, Hypophosphite und Borane verwendet werden.

Eine besonders bevorzugte Ausführungsform bei Verwendung der erfindungsgemäßen Formulierungen besteht darin, daß die Reduktion im Metallisierungsbad gleich mit dem Reduktionsmittel der stromlosen Metallisierung durchgeführt wird. Diese Ausführung ist besonders für aminboranhaltige Nickelbäder oder formalinhaltige Kupferbäder geeignet.

Die mit den erfindungsgemäßen Formulierungen aktivierten Oberflächen können in einem weiteren Verfahrensschritt metallisiert werden. Dafür kommen besonders Bäder mit Nickel-, Cobalt-, Eisen-, Kupfer-, Silber, Gold- und Palladiumsalzen oder deren Gemische in Betracht. Derartige Metallisierungsbäder sind in der Technik der stromlosen Metallisierung bekannt.

Die erfindungsgemäßen Formulierungen eigenen sich für eine ganzflächige, besonders aber für eine partielle Aktivierung von Oberflächen, ganz besonders zur Herstellung von gedruckten Schaltungen, Folientastaturen, Schaltmatten und Sensoren nach Druckverfahren insbesondere Sieb- und Tampondruckverfahren und anschließender additiven chemischen Metallisierung.

Beispiel 1

Aus 4,4-Diphenylmethan-diisocyanat und Trimellitsäureanhydrid wird in N-Methylpyrrolidon eine 40 %ige Lösung eines aromatischen Polyamidimids hergestellt.

| | |
|---|---|
| 250 Gew.-Teile | einer 40 %igen Lösung dieses aromatischen Polyamidimids, |
| 90 Gew.-Teile | Propylenglykolmethyletheracetat, |
| 2 Gew.-Teile | 3-Hepten-2-on-palladiumchlorid und |
| 15 Gew.-Teile | Aerosil® (200 m$^2$/g nach BET) |

werden in einer Perlmühle sorgfältig miteinander vermischt bzw. dispergiert.

Die entstehende Paste wird durch ein Sieb auf eine handelsübliche Polyimidfolie gedruckt und der Druck 1 Stunde bei 200°C getrocknet. Danach wird der Druck 5 Min. in einer 1 %igen Dimethylaminboranlösung reduziert und anschließend 40 Minuten in einem formalinhaltigen Kupferbad metallisiert. Man erhält eine zusammenhängende Metallschicht.

Haftfestigkeit gemäß DIN 53 151:     Kennwert GT 1.

Beispiel 2

Aus Isopropyliden-di-phthalsäureanhydrid und 2,2-Bis-4-aminophenoxyphenyl-propan wird in Butyrolacton eine 10 %ige Lösung eines Polyimids hergestellt.

| | |
|---|---|
| 270 Gew.-Teile | dieser 10 %igen Lösung in Butyrolacton werden mit |
| 130 Gew.-Teile | Glykolmethyletheracetat, |
| 3,3 Gew.-Teile | 5-Methyl-3-hexen-2-on-palladiumchlorid, |
| 30 Gew.-Teile | Bariumsulfat und |
| 10 Gew.-Teile | Aerosil® (200 m$^2$/g nach BET) |

über einen 3-Walzenstuhl sorgfältig miteinander vermischt.

Die entstehende Paste wird durch ein Sieb auf eine Polyimidfolie gedruckt, der Druck anschließend 2 Stunden bei 175°C getrocknet und wie im Beispiel 1 beschrieben metallisiert.

Beispiel 3

Aus Trimellitsäureanhydrid, 4,4'-Diphenylmethandiisocyanat und $\epsilon$-Caprolactam wird in Kresol eine 40 %ige heiße Lösung eines Polyamidimids hergestellt. Das Polymer wird durch Eingießen der Lösung in Methanol ausgefällt, getrocknet und fein vermahlen.

| | |
|---|---|
| 260 Gew.-Teile | einer 20 %igen Lösung dieses Polymeres in N-Methylcaprolactam werden mit |
| 130 Gew.-Teile | Methoxypropylacetat, |
| 2,2 Gew.-Teile | Butadienpalladiumdichlorid und |
| 20 Gew.-Teile | Aerosil® (380 m$^2$/g nach BET) |

im Dissolver sorgfältig vermischt bzw. dispergiert.

Die entstehende Paste wird durch ein Sieb auf eine handelsübliche Polyimidfolie gedruckt und 5 Minuten bei 300°C getrocknet. Anschließend wird der Druck 1 Stunde in einem formalinhaltigen Kupferbad metallisiert. Man erhält eine zusammenhängende Kupferschicht. Haftfestigkeit gemäß DIN 53 494: 27 N.

Beispiel 4

Eine Siebdruckpaste gemäß Beispiel 3 wird auf ein Metallblech gedruckt, das mit einem Polyamidimid aus Trimellitsäureanhydrid und 4,4-Diphenylmethandiisocyanat beschichtete wurde. Nach Trocken (1 h, 250°C) und Verkupfern des Druckes in einem formalinhaltigen Kupferbad (1 h) erhält man eine zusammenhängende Metallschicht.

Haftfestigkeit gemäß DIN 53 151:     Kennwert GT 1.

Beispiel 5

| | |
|---|---|
| 280 Gew.-Teile | einer 20 %igen Lösung eines Polyamidimids gemäß Beispiel 3 in N-Methylcaprolactam, |
| 130 Gew.-Teile | Glykolsäurebutylester, |
| 3 Gew.-Teile | Bis-acetonitril-palladiumdichlorid, |
| 35 Gew.-Teile | Titandioxid und |
| 0,1 Gew.-Teile | eines Siliconöls |

werden über einen 3-Walzenstuhl miteinander vermischt bzw. dispergiert.

Die Paste wird auf eine Polyamidimidfolie gedruckt und der Druck 2 Stunden bei 200°C getrocknet. Nach einstündiger Metallisierung in einem formalinhaltigen Kupferbad erhält man eine zusammenhängende Metallschicht.

Haftfestigkeit gemäß DIN 53 151:     Kennwert GT 0.
Haftfestigkeit gemäß DIN 53 494:     26 N.

Beispiel 6

| | |
|---|---|
| 250 Gew.-Teile | einer 20 %igen Polyamidimidlösung gemäß Beispiel 3, |
| 125 Gew.-Teile | Methoxypropylacetat, |
| 3 Gew.-Teile | Butadienpalladiumchlorid und |
| 30 Gew.-Teile | Aerosil® (380 m$^2$/g nach BET) |

werden in einem Dissolver vermischt bzw. dispergiert.

Die Paste wird auf eine Polyimidfolie (Kapton H 300) gedruckt und der Druck 5 Minuten bei 350°C getrocknet. Nach einstündiger Metallisierung des Druckes in einem formalinhaltigen Kupferbad erhält man eine zusammenhängende Metallschicht.

Haftfestigkeit gemäß DIN 53 151:     Kennwert GT 0.
Haftfestigkeit gemäß DIN 53 494:     nicht meßbar, da Kupferschicht nicht mehr von der Folie getrennt werden kann.

# EP 0 322 641 B1

**Patentansprüche**

1. Verfahren zur Verbesserung der Haftfestigkeit von stromlos abgeschiedenen Metallschichten auf Polyimid-Oberflächen durch Behandeln derselben mit bindemittelhaltigen Aktivatorformulierungen ohne Beizen, dadurch gekennzeichnet, daß sie als wesentliche Bestandteile
   a) 0,03 - 4,00 Gew-% einer organo-metallischen Edelmetallverbindung als Aktivator,
   b) 3 - 40 Gew.-% eines Polyimids,
   c) 1 - 30 Gew.-% eines Füllstoffs und
   d) 45 - 90 Gew.-% eines Lösungsmittels
   enthalten.

2. Verfahren nach Anspruch 1, dadurch gekennzeichnet, daß man als Aktivatoren metallorganische Verbindungen der 1. oder 8. Nebengruppe verwendet.

3. Verfahren nach Anspruch 1, dadurch gekennzeichnet, daß man als Bindemittel Polyimide verwendet, die durch Kondensation von cyclischen Polycarbonsäureanhydriden, Polycarbonsäurecarbonsäureanhydriden, Polycarbonsäuren oder Polycarbonsäureestern mit Polyaminen, Polyamiden, Polyisocyanaten oder Polycarbamidsäureestern erhältlich sind.

4. Verfahren nach Anspruch 1, dadurch gekennzeichnet, daß man als Bindemittel aliphatisch-aromatische Polyamidimide verwendet, die durch Kondensation von Trimellitsäureanhydrid mit Polyisocyanaten und Lactamen oder Polyamiden erhalten werden.

5. Verwendung von Formulierungen gemäß Anspruch 1 als Druckpasten zur Herstellung von gedruckten Schaltungen, Folientastaturen, Schaltmatten und Sensoren.

**Claims**

1. Process for improving the adhesive strength of electrolessly deposited metal layers on polyimide surfaces by treating the same with activator formulations containing binders without pickling, characterised in that they contain as essential constituents
   a) 0.03 - 4.00 % by weight of an organometallic noble-metal compound as activator,
   b) 3 - 40 % by weight of a polyimide,
   c) 1 - 30 % by weight of a filler and
   d) 45 - 90 % by weight of a solvent.

2. Process according to Claim 1, characterised in that organometallic compounds of the 1st or 8th subgroup are used as activators.

3. Process according to Claim 1, characterised in that polyimides which can be obtained by condensation of cyclic polycarboxylic acid anhydrides, polycarboxylic acid carboxylic acid anhydrides, polycarboxylic acids or polycarboxylic acid esters with polyamines, polyamides, polyisocyanates or polycarbamic acid esters are used as binders.

4. Process according to Claim 1, characterised in that aliphatic-aromatic polyamideimides which are obtained by condensation of trimellitic anhydride with polyisocyanates and lactams or polyamides are used as binders.

5. Use of formulations according to Claim 1 as printing pastes for producing printed circuits, foil keyboards, switching mats and sensors.

**Revendications**

1. Procédé pour améliorer l'adhérence de couches métalliques déposées sans courant sur des surfaces de polyimide en traitant ces surfaces avec des formulations d'activateur contenant des liants sans appliquer de traitement d'attaque, caractérisées en ce qu'elles contiennent
   a) 0,03 à 4,00% en poids d'un composé organométallique de métal précieux comme activateur,
   b) 3 à 40% en poids d'un polyimide,

c) 1 à 30% en poids d'une charge et

d) 45 à 90% en poids d'un solvant.

**2.** Procédé selon la revendication 1, caractérisé en ce qu'on emploie comme activateur des composés organo-métalliques des groupes secondaires 1 ou 8.

**3.** Procédé selon la revendication 1, caractérisé en ce qu'on emploie comme liant des polyimides pouvant être obtenus par condensation d'anhydrides d'acides polycarboxyliques cycliques , d'anhydrides d'acides polycarboxyliques-acides carboxyliques, d'acides polycarboxyliques ou d'esters d'acides polycarboxyliques avec des polyamines, des polyamides, des polyisocyanates ou des esters d'acides polycarbamiques.

**4.** Procédé selon la revendication 1, caractérisé en ce qu'on emploie comme liants des polyamideimides aliphatiques-aromatiques obtenus par condensation d'anhydride trimellitique avec des polyisocyanates et des lactames ou des polyamides.

**5.** Utilisation des formulations selon la revendication 1 comme pâtes d'impression pour la fabrication de circuits imprimés, de claviers à affleurement, de nattes de contact et de capteurs.